# EUROPEAN PATENT SPECIFICATION

(11) **EP 3 886 148 B1**
(45) Date of publication and mention of the grant of the patent: **17.04.2024**
(21) Application number: 19887854.8
(22) Date of filing: 24.10.2019
(51) Int. Cl.: H01L 21/67, H01L 21/02, B08B 5/00

(54) **APPARATUS FOR REMOVING PARTICLES USING SYMMETRICAL GAS INJECTION**
VORRICHTUNG ZUM ENTFERNEN VON PARTIKELN MITTELS SYMMETRISCHER GASEINBLASUNG
APPAREIL D'ÉLIMINATION DE PARTICULES À L'AIDE D'UNE INJECTION DE GAZ SYMÉTRIQUE

(30) Priority: 23.11.2018 KR 20180146303
(43) Date of publication of application: 29.09.2021
(73) Proprietor: Kim, Jin Ho, Gyeonggi-do 16517 (KR)
(72) Inventor: Kim, Jin Ho, Gyeonggi-do 16517 (KR)
(74) Representative: Pietri, Simona
(86) International application number: PCT/KR2019/014062
(87) International publication number: WO 2020/105875

(56) References cited:
- FR-A1- 2 933 012
- JP-B2- 3 452 676
- KR-A- 20060 019 247
- KR-A- 20080 001 428
- KR-A- 20080 001 428
- KR-B1- 100 589 107
- KR-B1- 101 641 390
- KR-B1- 101 874 809

## Description

### [Technical Field]

The present invention relates to an apparatus for removing particles, and more particularly, to an apparatus for removing particles using symmetrical gas injection for effectively removing and recovering particles from the surface of an object in a clean room and the like.

### [Background Art]

In general, with the advancement of the industry, in a production site as well as an office environment, a need to control particles such as dust has increased, and a clean room was introduced to maintain the production site in a clean state to prevent adverse effects of the particles on a product.

Such a clean room is introduced and operating in industry and science laboratories such as semiconductors, displays, pharmacies, hospitals, etc. In particular, in a high-tech industry including nano-scale and high-precise processes such as a manufacturing process of a semiconductor or an LCD display, since microenvironmental conditions at sites where products are manufactured may also greatly affect the quality of the products, the cleanliness required in the clean room tends to be gradually increasing. For example, in the semiconductor manufacturing process, pattern defects caused by depositing particles oscillated from an automated device or the like on a wafer surface have been pointed out as a major cause of yield reduction of the products.

As such, when particles are present at the site of manufacturing the products in a high-tech industry, the particles may be reversed to the products during the manufacturing process to cause fatal product defects. These particles are accumulated in ceilings, walls, and floors in the site of manufacturing the products, production and measurement facilities, and various resources and also attached to worker's clothing. In addition, since the movement of airflow is caused according to movement of robots, workers, and products and the imbalance of spatial temperature, particles which have been accumulated on the surfaces of workers, objects, or adjacent portions thereof are reversed to contaminate the products, resulting in product defects.

As the related arts for removing particles, in US Patent Registration No. 5,253,538 (issued on October 19, 1993), there is disclosed a device for counting particles on a surface by a vacuum suction method in which when a sample surface is suctioned by an air pump through a scanner, the particles are filtered through a laser diode light source counter and a filter.

However, since an ability of separating particles from the sample surface is deteriorated by suctioning the particles by the vacuum suction method, recently, there is a problem that microparticles of several µm or less required in semiconductor and display industries cannot be removed.

Further, in Korean Patent Publication No. 10-2008-0017768 (published on February 27, 2008), there is disclosed an apparatus for removing particles by a gas spraying method including a substrate transfer device on which a substrate is placed, a gas spray unit which sprays gas on the substrate transfer device while being inclined at a predetermined angle to remove particles attached on the substrate, and a suction unit which faces the gas spray unit on the substrate transfer device and suctions the particles removed from the substrate while being inclined at a predetermined angle.

However, the particles removed from the substrate are spread around by airflow of the sprayed gas so that the contamination occurs. Even after the spraying is completed, the particles are attached to another position of the substrate while transferring by the airflow again, so that re-contamination may occur. In addition, there is a problem that it is difficult to accurately recover, detect and count the particles, and there is a risk that a worker inhales the particles during an operation.

KR20080001428 discloses an apparatus for removing particles.

### [Disclosure]

### [Technical Problem]

The present invention is derived to solve all the aforementioned problems, and an object of the present invention is to provide an apparatus for removing particles using symmetrical gas injection in which gas nozzles inject in symmetrical directions to prevent diffusion of particles removed from the surface of an object, the object is not contaminated, and the particles are able to be accurately recovered, detected and counted.

### [Technical Solution]

In order to solve the objects, the present invention provides an apparatus for removing particles using symmetrical gas injection as claimed in claim 1.

### [Advantageous Effects]

According to the present invention, there is an effect that the gas nozzles inject in symmetrical directions to prevent diffusion of particles removed from the surface of an object, the object is not contaminated, and the particles are able to be accurately recovered, detected and counted.

Further, there is an effect that even when the vacuum is not formed in the recovery part, the particles are able to be transferred to a predetermined distance and recovered, and even if imbalance occurs on a pressure or injection amount of the injection gas injected in the symmetrical directions or the injection gas are irregularly diffused after colliding depending on various shapes of the surface of the object, the particles are able to be induced in a desired direction and recovered.

Further, there is an effect that the particles are able to be more accurately detected and counted by injecting cleaning gas to prevent foreign substances from being introduced to the recovery part, automatic control is enabled by setting injection time and injection intervals depending on the surface shape of the object, and the particles are able to be smoothly collected and recovered.

### [Description of Drawings]

FIG. 1 is a diagram illustrating an apparatus for removing particles and auxiliary facilities according to an embodiment of the present invention.
FIG. 2 is a perspective view illustrating an apparatus for removing particles according to an embodiment of the present invention.
FIGS. 3A to 3D are plan views illustrating arrangements of gas nozzles according to an embodiment of the present invention and FIG. 3E is a side view.
FIG. 4 is a diagram illustrating a recovery operation of particles removed from the surface of an object according to an embodiment of the present invention.
FIG. 5 is a schematic view of further comprising a second recovery part according to an embodiment of the present invention.

### [Modes for the Invention]

Hereinafter, detailed contents for implementing an apparatus for removing particles using symmetrical gas injection according to the present invention will be described based on embodiments with reference to the accompanying drawings.

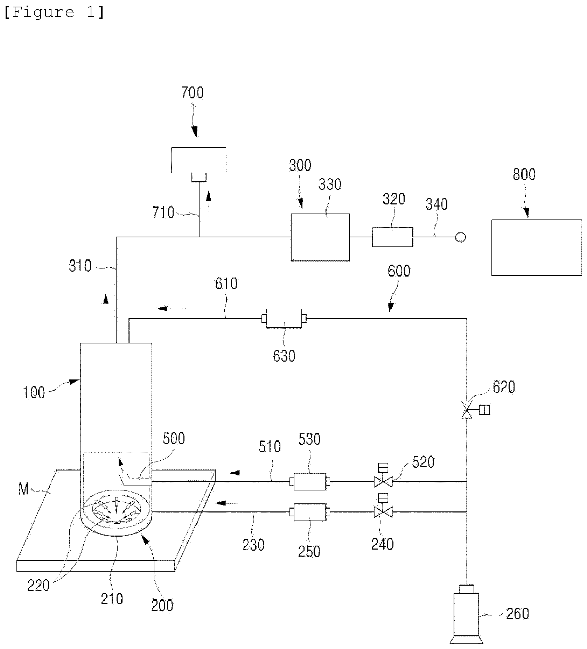

An apparatus for removing particles using symmetrical gas injection according to the present invention is to effectively remove and recover particles from the surface of an object in a clean room and the like. Referring to FIG. 1, the apparatus for removing particles may include a casing 100, a gas injection part 200, and a recovery part 300 and selectively further include a second recovery part 400, a direction induction nozzle 500, a cleaning gas injection part 600, a particle detection part 700, and a control part 800.

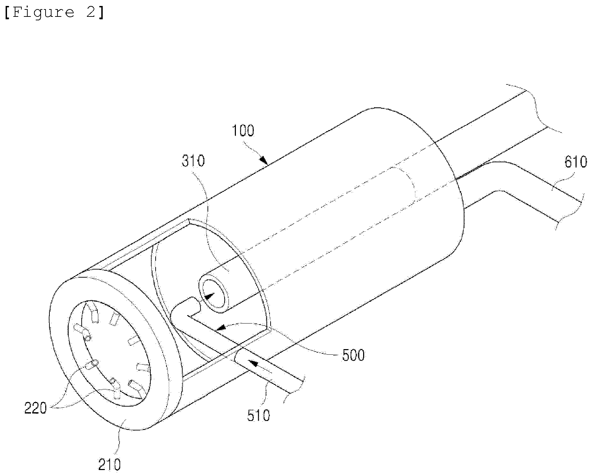

Referring to FIG. 2, the casing 100 has an inner space, may be provided in a vertical or horizontal direction, and provides a space in which particles P removed from the surface of the object are induced to the recovery part 300.

The gas injection part 200 has a nozzle block 210 formed at one side of the casing 100, the nozzle block 210 has a ring or strip shape in which a central portion penetrates so that the surface of an object M is exposed to gas nozzles 220, and the object M may be seated and supported on a support.

The nozzle block 210 may have a shape such as a circular ring or a quadrangular ring, but is not particularly limited to the shape.

The nozzle block 210 is connected to a gas supply pipe 230 to distribute gas supplied from the gas supply pipe 230 to a plurality of gas nozzles 220 through the nozzle block 210. The gas supply pipe 230 is connected to an air compressor 260 to receive compressed gas and an opening/closing valve 240 that is automatically controlled to be opened and closed by the control part 800, and an air filter 250 are provided.

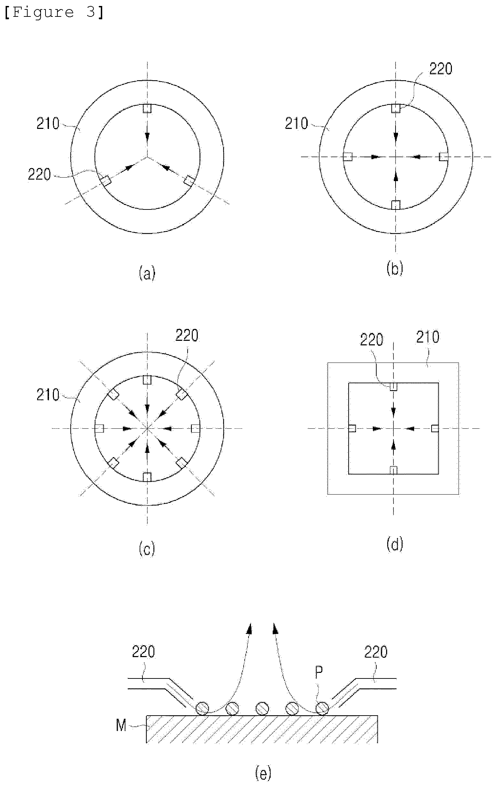

Referring to FIG. 3, the plurality of gas nozzles 220 is provided along the nozzle block 210, wherein the plurality of gas nozzles 220 are provided to be symmetrical to each other and inclined at a predetermined angle toward the object M to be spaced apart from the object M, and the particles P attached to the surface of the object M are removed by injecting the gas to the object M.

Generally, the symmetry includes point symmetry, line symmetry, plane symmetry, etc., and elements of the symmetry include a symmetrical center, a symmetrical axis, and a symmetrical plane. The symmetrical center refers to a point where a line connected through the symmetrical center is divided into equal parts by the symmetrical center, the symmetrical axis refers to an axis which has the same shape two or more times when rotating the object at 360° on an axis of one vertical line, and includes a 2-fold symmetrical axis, a 3-fold symmetrical axis, a 4-fold symmetrical axis, a 8-fold symmetrical axis, etc. The symmetrical plane refers to a plane that two half parts of the object have the same shape based on a mirror surface.

For example, two gas nozzles may also be provided in the nozzle block 210 to be symmetrical to each other. Three gas nozzles 220 illustrated in FIG. 3A are provided in the nozzle block 210 to be symmetrical to each other by a 3-fold symmetrical axis and four gas nozzles 220 illustrated in FIG. 3B are provided in the nozzle block 210 to be symmetrical to each other by a 4-fold symmetrical axis. FIG. 3C illustrates that four gas nozzles 220 are provided in the nozzle block 210 to be symmetrical to each other by a 8-fold symmetrical axis, and FIG. 3D illustrates that the nozzle block is formed in a quadrangular ring shape and four gas nozzles 220 are disposed to be symmetrical to each other by a 4-fold symmetrical axis. FIG. 3E is a side view illustrating the arrangement and operation of the gas nozzles disposed to be symmetrical to each other as described above.

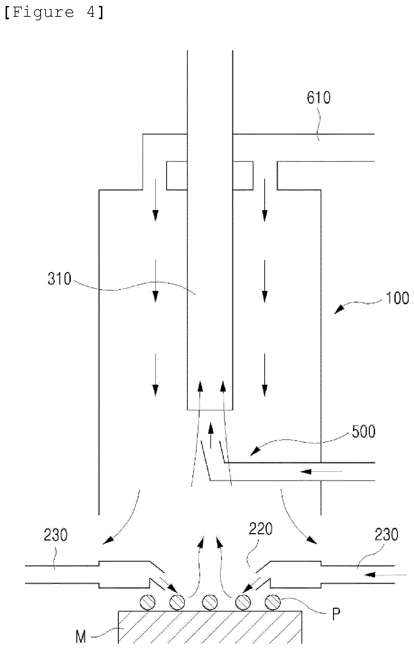

The gas nozzles 220 disposed to be symmetrical to each other as described above inject the same amount of gas toward the object M at a predetermined angle with the same pressure. Referring to FIG. 4, the symmetrically injected gas collides with the surface of the object M to remove the particles P from the object M and then ascends upward from the central portion of the nozzle block 210 together with the particles P removed by colliding with each other. As such, the particles removed from the surface of the object M by the gas injected in symmetrical directions to each other are prevented from being diffused around, the contamination of the object M does not occur, and the particles are induced to the recovery part 300 to be able to be accurately recovered, detected, and counted.

In the recovery part 300, a recovery pipe 310 is connected to the other side of the casing 100, that is, an opposite side of the nozzle block 210, a part of the recovery pipe 310 is inserted into the casing 100, and a recovery port corresponding to a pipe inlet is formed at an end of the recovery pipe. At this time, the recovery port may also be formed so that the diameter is gradually increased toward the end, and the particles P removed from the object M by the gas symmetrically injected from the gas nozzles 220 are recovered on a passage of the recovery pipe 310 through the recovery port.

The recovery pipe 310 is connected to a vacuum pump 330 to suction the particles P by a vacuum suction method and discharge the particles P through a discharge pipe 340, and a membrane filter 320 is provided on the recovery passage of the recovery pipe 310 to collect the recovered particles P. Further, a particle collector such as the membrane filter 320 is provided in the recovery pipe 310 to collect the particles P, thereby confirming the contamination and the degree thereof.

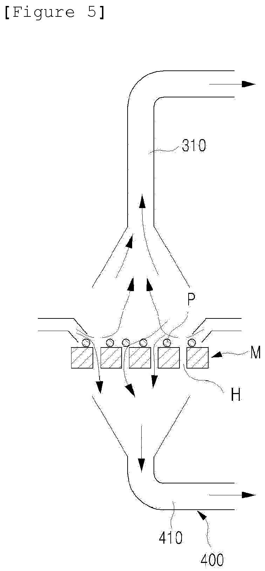

Referring to FIG. 5, if a hole is formed in the object M, the second recovery part 400 is additionally provided even on a back side of the object M to recover the particles P removed from the object M together with the gas through a second recovery pipe 410 by the gas symmetrically injected from the gas nozzles 220, thereby preventing the particles removed from the surface of the object M and the gas passing through the hole from being diffused around. At this time, a recovery port corresponding to the pipe inlet is formed at the end of the second recovery pipe 410, wherein the recovery port may also be formed so that the diameter is gradually increased toward the end.

The direction induction nozzle 500 is connected to a direction induction pipe 510 and formed in the middle of the casing 100 and serves to induce the particles P removed from the object M in a desired direction by injecting direction induced gas toward the recovery pipe 310 of the recovery part 300. At this time, the direction induction pipe 510 is connected with the air compressor 260 to receive compressed gas and an opening/closing valve 520 that is automatically controlled to be opened and closed by the control part 800, and an air filter 530 are provided.

The direction induction nozzle 500 induces the particles P removed from the object M to the recovery pipe 310 by injecting the direction induced gas toward the inlet of the recovery pipe 310 even when the vacuum is not formed in the recovery pipe 310 to transmit and recover the particles by a predetermined distance. Even if imbalance occurs on a pressure or injection amount of the gas injected in the symmetrical directions of the gas nozzles 220 or the injected gas is irregularly diffused after colliding according to various shapes of the surface of the object, the direction induction nozzle 500 may induce and recover the particles P removed from the object M in a desired direction by injecting the direction induced gas toward the inlet of the recovery pipe 310.

In the cleaning gas injection part 600, a gas injection pipe 610 is connected to the other of the casing 100, that is, an opposite side of the nozzle block 210, the gas injection pipe 610 is connected with the air compressor 260 to receive compressed gas, and an opening/closing valve 620 which is automatically controlled to be opened and closed by the control part 800, and an air filter 630 are provided. At this time, cleaning gas injected from the cleaning gas injection part 600 moves in a longitudinal direction inside the casing 100 along an outer side of the recovery pipe 310.

That is, when the gas with a predetermined pressure is injected toward the surface of the object M from the gas nozzles 220, some of gas around the gas nozzles 220 is swept out together to the central portion of the nozzle block 210. At this time, foreign materials which have existed around also move together to be introduced to the recovery pipe 310 and then mixed with the particles P removed from the object M, so that it may be difficult to accurately measure the particles during detection and counting by the particle detection part 700 connected with the recovery part 300.

As a result, when the cleaning gas is injected at a predetermined pressure along the inside of the casing 100, more particularly, the periphery of the recovery part 310 through the gas injection pipe 610, foreign substances other than the particles P are prevented from being introduced to the recovery part 300 and thus, it is possible to more accurately detect and count the particles P removed from the object M. At this time, the cleaning gas is injected in a direction opposite to the direction of the particles P introduced to the recovery part 300.

In the particle detection part 700, a suction port 710 is connected with the recovery pipe 310 of the recovery part 300 to suction the particles P moving on the recovery passage of the recovery pipe 310, thereby detecting or counting the particles. The number, the sizes, the distribution, etc. of the particles P are measured by detecting and the counting the particles P, thereby easily and rapidly checking the contamination and the degree thereof in the clean room and further preventing defects of products.

The control part 800 controls the opening/closing valve 240 of the gas injection part 200 to automatically control the injection time and the inject intervals of the gas. Further, the control part 800 also controls and open/closes the opening/closing valves 520 and 620 to control the injection time and the injection amounts of the direction induced gas and the cleaning gas injected to the direction induction nozzle 500 and the gas injection pipe 610.

When the gas is continuously injected from the gas nozzles 220, the injection amount is greatly increased, and as a result, there is a problem that the gas moves to a desired distance or more and the scale of the recovery part 300 needs to be increased by the distance. Accordingly, the control part 800 controls the opening/closing valve 240 according to a prestored setting so as to fit the scale of the recovery part 300 such as the size, a suction force, etc. of the recovery pipe 310, so that the gas is intermittently injected, thereby smoothly recovering and collecting the particles P. For example, if the recovery part 300 may recover a gas injection amount per 1 second of the gas nozzles 220 after 10 seconds, the control part 800 controls the opening/closing valve 240 to have a pause time of 10 seconds after the gas nozzles 220 inject the gas for 1 second.

In the present invention, the embodiment is one example and the present invention is not limited thereto.

The invention is defined by the appended claims.

### [Industrial Applicability]

Since the gas nozzles inject in symmetrical directions to prevent diffusion of particles removed from the surface of an object, the object is not contaminated, and the particles are able to be accurately recovered, detected and counted, the apparatus for removing the particles using the symmetrical gas injection according to the present invention has industrial applicability.

## Claims

1. An apparatus for removing particles (P) using symmetrical gas injection, the apparatus comprising:
a casing (100) having an inner space;
a gas injection part (200) in which a plurality of gas nozzles (220) are formed on a first side of the casing (100), the plurality of gas nozzles (220) are disposed symmetrically and away from an object (M), and particles (P) on the surface of the object (M) are removed by injecting gas on the object (M);
a recovery part (300) which has a recovery pipe (310) connected to a second side of the casing (100), opposite of the first side and inserted therein and configured to recover the particles (P) removed from the object (M) to the recovery pipe (310);
a direction induction nozzle (500) which is formed in the casing (100) and configured to inject direction induced gas toward an inlet of the recovery pipe (310) to induce the particles (P) removed from the object (M) in a desired direction; and
a cleaning gas injection part (600) which is connected to the second side of the casing (100) and configured to inject cleaning gas to the inside of the casing (100), wherein the cleaning gas moves in a longitudinal direction inside the casing (100) along an outer side of the recovery pipe (310) to prevent foreign substances existing around the gas nozzles (220) from being introduced to the recovery part (300).

2. The apparatus for removing particles (P) using gas injection of claim 1, further comprising:
a particle detection part (700) which is connected with the recovery pipe (310) of the recovery part (300) to detect and count the suctioned particles (P).

3. The apparatus for removing particles (P) using gas injection of claim 1, wherein a membrane filter (320) is provided in the recovery pipe (310) to be able to collect the particles (P).

4. The apparatus for removing particles (P) using gas injection of claim 1, further comprising:
a control part (800) configured to control an opening/closing valve (240) of the gas injection part (200) to automatically control the injection time and the injection intervals of the gas.

## Patentansprüche

1. Vorrichtung zum Entfernen von Partikeln (P) unter Verwendung einer symmetrischen Gasinjektion, die Vorrichtung umfassend:
ein Gehäuse (100), das einen Innenraum aufweist;
ein Gasinjektionsteil (200), in dem eine Vielzahl von Gasdüsen (220) auf einer ersten Seite des Gehäuses (100) ausgebildet sind, wobei die Vielzahl von Gasdüsen (220) symmetrisch und weg von einem Objekt (M) angeordnet sind und Partikel (P) auf der Oberfläche des Objekts (M) durch das Injizieren von Gas auf das Objekt (M) entfernt werden;
ein Rückgewinnungsteil (300), das ein Rückgewinnungsrohr (310) aufweist, das mit einer zweiten Seite des Gehäuses (100) verbunden ist, gegenüberliegend der ersten Seite und darin eingesetzt und konfiguriert, um die Partikel (P), die von dem Objekt (M) entfernt werden, zu dem Rückgewinnungsrohr (310) zurückzuführen;
eine Richtungsinduktionsdüse (500), die in dem Gehäuse (100) ausgebildet und konfiguriert ist, um richtungsinduziertes Gas zu einem Einlass des Rückgewinnungsrohrs (310) hin zu injizieren, um die von dem Objekt (M) entfernten Partikel (P) in einer gewünschten Richtung zu induzieren; und
ein Reinigungsgasinjektionsteil (600), das mit der zweiten Seite des Gehäuses (100) verbunden und konfiguriert ist, um Reinigungsgas in das Innere des Gehäuses (100) zu injizieren, wobei sich das Reinigungsgas in einer Längsrichtung innerhalb des Gehäuses (100) entlang einer Außenseite des Rückgewinnungsrohrs (310) bewegt, um zu verhindern, dass Fremdstoffe, die um die Gasdüsen (220) herum vorhanden sind, in das Rückgewinnungsteil (300) eingeleitet werden.

2. Vorrichtung zum Entfernen von Partikeln (P) unter Verwendung von Gasinjektion nach Anspruch 1, ferner umfassend:
ein Partikelerfassungsteil (700), das mit dem Rückgewinnungsrohr (310) des Rückgewinnungsteils (300) verbunden ist, um die angesaugten Partikel (P) zu erfassen und zu zählen.

3. Vorrichtung zum Entfernen von Partikeln (P) unter Verwendung von Gasinjektion nach Anspruch 1, wobei ein Membranfilter (320) in dem Rückgewinnungsrohr (310) bereitgestellt ist, um in der Lage zu sein, die Partikel (P) zu sammeln.

4. Vorrichtung zum Entfernen von Partikeln (P) unter Verwendung von Gasinjektion nach Anspruch 1, ferner umfassend:
ein Steuerteil (800), das konfiguriert ist, um ein Öffnungs-/Schließventil (240) des Gasinjektionsteils (200) zu steuern, um die Injektionszeit und die Injektionsintervalle des Gases automatisch zu steuern.

## Revendications

1. Appareil permettant d'éliminer des particules (P) à l'aide d'une injection de gaz symétrique, l'appareil comprenant :
un boîtier (100) ayant un espace interne ;
une partie d'injection de gaz (200) dans laquelle une pluralité de buses de gaz (220) sont formées sur un premier côté du boîtier (100), la pluralité de buses de gaz (220) sont disposées symétriquement et à distance d'un objet (M), et des particules (P) sur la surface de l'objet (M) sont retirées par injection de gaz sur l'objet (M) ;
une partie de récupération (300) qui a un tuyau de récupération (310) raccordé à un second côté du boîtier (100), opposé au premier côté et inséré dans celui-ci et conçu pour récupérer les particules (P) retirées à partir de l'objet (M) vers le tuyau de récupération (310) ;
une buse d'induction de direction (500) qui est formée dans le boîtier (100) et conçue pour injecter un gaz induit de direction vers une entrée du tuyau de récupération (310) pour induire les particules (P) retirées de l'objet (M) dans une direction souhaitée ; et
une partie d'injection de gaz de nettoyage (600) qui est raccordée au second côté du boîtier (100) et conçue pour injecter du gaz de nettoyage à l'intérieur du boîtier (100), dans lequel le gaz de nettoyage se déplace dans une direction longitudinale à l'intérieur du boîtier (100) le long d'un côté externe du tuyau de récupération (310) pour empêcher des substances étrangères existant autour des buses de gaz (220) d'être introduites dans la partie de récupération (300).

2. Appareil permettant d'éliminer des particules (P) à l'aide d'une injection de gaz selon la revendication 1, comprenant en outre :
une partie de détection de particules (700) qui est reliée au tuyau de récupération (310) de la partie de récupération (300) pour détecter et compter les particules aspirées (P).

3. Appareil permettant d'éliminer des particules (P) à l'aide d'une injection de gaz selon la revendication 1, dans lequel un filtre à membrane (320) est pourvu dans le tuyau de récupération (310) pour pouvoir collecter les particules (P).

4. Appareil permettant d'éliminer des particules (P) à l'aide d'une injection de gaz selon la revendication 1, comprenant en outre :
une partie de commande (800) configurée pour commander une vanne d'ouverture/fermeture (240) de la partie d'injection de gaz (200) pour réguler automatiquement le temps d'injection et les intervalles d'injection du gaz.
